# EUROPEAN PATENT SPECIFICATION

(11) **EP 4 481 415 B1**
(45) Date of publication and mention of the grant of the patent: **23.09.2026**
(21) Application number: 23756519.7
(22) Date of filing: 11.01.2023
(51) Int. Cl.: G01R 31/392, G01R 31/3835, G01R 19/145, G01R 19/25, B60L 3/00, G01R 31/52

(54) **BATTERY MANAGEMENT APPARATUS AND OPERATION METHOD THEREOF**
BATTERIEVERWALTUNGSVORRICHTUNG UND BETRIEBSVERFAHREN DAFÜR
APPAREIL DE GESTION DE BATTERIE ET SON PROCÉDÉ DE FONCTIONNEMENT

(30) Priority: 17.02.2022 KR 20220021121
(43) Date of publication of application: 25.12.2024
(73) Proprietor: LG Energy Solution, Ltd., Seoul 07335 (KR)
(72) Inventor: KIM, Min Woo, Daejeon 34122 (KR); CHOI, Jang Hyeok, Daejeon 34122 (KR); KIM, Tae Youn, Daejeon 34122 (KR)
(74) Representative: Goddar, Heinz J.
(86) International application number: PCT/KR2023/000509
(87) International publication number: WO 2023/158106

(56) References cited:
- WO-A1-2021/125678
- WO-A1-2022/019526
- KR-B1- 101 440 531
- KR-B1- 101 440 531
- KR-B1- 102 052 956
- KR-B1- 102 052 956
- KR-B1- 102 056 876
- KR-B1- 102 291 762
- US-A1- 2014 028 322
- US-A1- 2014 285 156
- US-A1- 2014 306 667
- US-A1- 2019 047 436
- US-A1- 2019 097 438
- US-A1- 2019 379 217
- US-A1- 2020 011 929
- US-A1- 2020 142 002

## Description

### [TECHNICAL FIELD]

### CROSS-REFERENCE TO RELATED APPLICATION

This application claims priority to and the benefit of Korean Patent Application No. 10-2022-0021121 filed in the Korean Intellectual Property Office on February 17, 2022.

### TECHNICAL FIELD

The present invention relates to a battery management apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

For a battery, safety has to be increased by preventing fire occurrence. International functional safety has been distributed to prevent accidents caused by functional errors in electrical or electronic devices including batteries, and a device including a battery may need various diagnosis circuits or software to satisfy various standards.
KR 102052956 B1 discloses a relay diagnostic device comprising: a control unit; a first relay and a second relay respectively disposed on a positive power line and a negative power line between a battery pack and a load; a first measuring device positioned between the battery pack and the load and including a first measuring unit, a first voltage dividing unit, and a second switch electrically connected between the positive power line and the negative power line; and a second measuring device positioned between the battery pack and the load and including a second measuring unit, a second voltage dividing unit, and a third switch.

### [DISCLOSURE]

### [TECHNICAL PROBLEM]

The present invention aims to provide a battery management apparatus and an operating method thereof in which connectivity of an inside of a battery pack and a connectivity of a load may be diagnosed.

The present invention aims to provide a battery management apparatus and an operating method thereof in which both connectivity of a battery pack side and connectivity of a load side may be diagnosed with one voltage measuring device.

Technical problems of the invention are not limited to the above-described technical problems, and other unmentioned technical problems would be clearly understood by one of ordinary skill in the art from the following description.

### [TECHNICAL SOLUTION]

The invention is set out in the appended claims. A battery management apparatus according to the invention includes a first relay configured to connect an end of a battery pack to an end of a load, a second relay configured to connect the other end of the battery pack to the other end of the load, a measuring unit configured to measure voltages of the battery pack and the load, and a controller configured to control operations of the first relay and the second relay and obtain the voltage of the battery pack or the voltage of the load based on the operations of the first relay and the second relay.

In an embodiment, the controller may be further configured to obtain the voltage of the battery pack when both the first relay and the second relay are opened.

In an embodiment, the controller may be further configured to open the first relay, short-circuit the second relay, and obtain the voltage of the load.

In an embodiment, the measuring unit may further include an analog-to-digital converter (ADC).

The controller is further configured to diagnos that abnormality has occurred in connectivity of the battery pack when the voltage of the battery pack is less than a first set value, and to diagnos that abnormality has occurred in connectivity of the load when the voltage of the load exceeds a second set value.

In an embodiment, the measuring unit may be located outside the battery pack.

In an embodiment, the first relay may be a positive relay, and the second relay may be a negative relay.

In an embodiment, the controller may be further configured to match a ground of the load to a ground of the battery pack by short-circuiting the second relay.

In an embodiment, the controller may be further configured to diagnose connectivity of the battery pack by opening both the first relay and the second relay, diagnose connectivity of the load by short-circuiting the second relay, and short-circuit both the first relay and the second relay when a connectivity diagnosis result of the battery pack and a connectivity diagnosis result of the load are normal.

In an embodiment, the measuring unit and the battery pack may form a closed circuit when both the first relay and the second relay are opened.

In an embodiment, the measuring unit and the load may form a closed circuit when the first relay is opened and the second relay is short-circuited.

An operating method of a battery management apparatus according to the invention includes measuring voltages of the battery pack and the load, controlling operations of a first relay and a second relay, and obtaining the voltage of the battery pack or the voltage of the load based on the operations of the first relay and the second relay, in which the first relay and the second relay connect the battery pack to the load.

In an embodiment, the obtaining of the voltage of the battery pack or the voltage of the load based on the operations of the first relay and the second relay may include obtaining the voltage of the battery pack when the first relay is opened and the second relay is opened.

In an embodiment, the obtaining of the voltage of the battery pack or the voltage of the load based on the operations of the first relay and the second relay may include obtaining the voltage of the load when the first relay is opened and the second relay is short-circuited.

In an embodiment, the operating method may further include diagnosing that abnormality has occurred in connectivity of the battery pack when the voltage of the battery pack is less than a first set value and diagnosing that abnormality has occurred in connectivity of the load when the voltage of the load exceeds a second set value.

### [ADVANTAGEOUS EFFECTS]

The battery management apparatus and the operating method thereof according to the invention may diagnose connectivity of a battery pack side and connectivity of a load side.

The battery management apparatus and the operating method thereof according to the invention may measure a battery pack-side voltage and a load-side voltage through one ADC, and diagnose the connectivity of the battery pack side and the load side voltage based on the measured voltages.

The battery management apparatus and the operating method thereof according to the invention may diagnose the connectivity of the both sides with a simplified circuit by matching grounds of the battery pack side and the load side.

Moreover, various effects recognized directly or indirectly from the disclosure may be provided.

### [DESCRIPTION OF DRAWINGS]

FIG. 1 is a block diagram of a general battery pack.
FIG. 2 is a view showing an environment including a battery management apparatus, according to an embodiment disclosed herein.
FIG. 3 shows an example of measuring a voltage of a battery pack according to an embodiment disclosed herein.
FIG. 4 shows an example of measuring a voltage on a load side according to an embodiment disclosed herein.
FIG. 5 is a flowchart of an operating method of a battery management apparatus according to an embodiment disclosed herein.
FIG. 6 is a flowchart showing an operating method of a battery management apparatus, according to an embodiment disclosed herein.
FIG. 7 is a block diagram showing a hardware configuration of a computing system for performing an operating method of a battery management apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

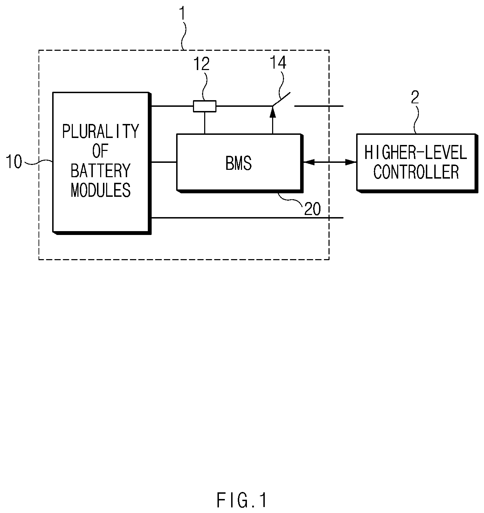

FIG. 1 is a block diagram of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a battery module 10 that includes one or more battery cells and is chargeable/dischargeable, a switching unit 14 serially connected to a positive (+) terminal side or a negative (-) terminal side of the battery module 10 to control a charging/discharging current flow of the battery module 10, and a battery management system (e.g., RBMS) 20 for control and management to prevent over-charging and over-discharging by monitoring a voltage, a current, a temperature, etc., of the battery pack 1. The battery pack 1 may include the battery module 10, the sensor 12, the switching unit 14, and the battery management system 20 provided in plural.

Herein, as the switching unit 14 which is an element for controlling a current flow for charging or discharging of the plurality of battery modules 10, for example, at least one relay, magnetic contactor, etc., may be used according to specifications of the battery pack 1.

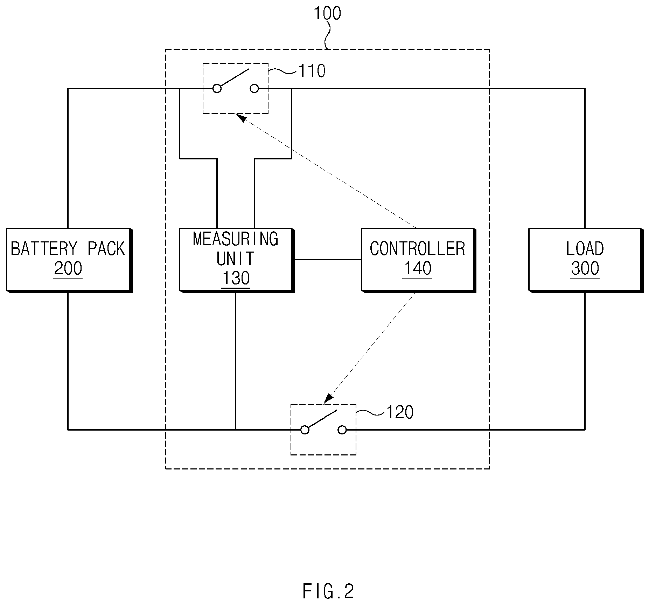

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the battery module 10 to monitor the state of each battery module 10. According to an embodiment, the battery management system 20 may include a battery management apparatus 100 of FIG. 2. According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1.

The higher-level controller 2 may transmit a control signal regarding the battery module 10 to the battery management system 20. Thus, the battery management system 20 may also be controlled in terms of an operation thereof based on a signal applied from the higher-level controller 2.

FIG. 2 is a view showing an environment including a battery management apparatus, according to an embodiment disclosed herein.

Referring to FIG. 2, the battery management apparatus 100 according to an embodiment disclosed herein may include a first relay 110, a second relay 120, a measuring unit 130, and a controller 140. According to an embodiment, the battery pack 200 may be substantially the same as the battery pack 1 of FIG. 1. According another embodiment, the battery management apparatus 100 may be included in the battery pack 200 and may be another device outside the battery pack 200.

The first relay 110 may connect the battery module 200 with the load 300. For example, the first relay 110 may be a positive relay or a main relay. According to an embodiment, an operation of the first relay 110 may be controlled by the controller 140. According to an embodiment, the first relay 110 may include a BJT or a MOSFET.

The second relay 120 may be different from the first relay 110, and may connect the battery pack 200 with the load 300. For example, the second relay 120 may be a negative relay. According to an embodiment, an operation of the second relay 120 may be controlled by the controller 140. According to an embodiment, the second relay 120 may include a BJT or a MOSFET.

The measuring unit 130 may measure voltages of the battery pack 200 and the load 300. For example, the measuring unit 130 may include an analog-to-digital converter (ADC).

Depending on an embodiment, the measuring unit 130 may be located outside the battery pack 200. For example, as the voltage of the battery pack 200 is high, the measuring unit 130 may measure the voltage of the battery pack 200 after lowering the voltage. In another example, to lower the voltage of the battery pack 200 and apply the voltage to the measuring unit 130, the measuring unit 130 may be located outside the battery pack 200.

The controller 140 may control operations of the first relay 110 and the second relay 120. For example, the controller 140 may generate control signals for controlling the operations of the first relay 110 and the second relay 120 to control the operations of the first relay 110 and the second relay 120.

The controller 140 may obtain a voltage of the battery pack 200 or a voltage of the load 300 based on the operations of the first relay 110 and the second relay 120. For example, the controller 140 may obtain the voltage of the battery pack 200 when both the first relay 110 and the second relay 120 are opened. According to an embodiment, the controller 140 may open both the first relay 110 and the second relay 120, and obtain the voltage of the battery pack 200 through the measuring unit 130.

According to an embodiment, the controller 140 may obtain the voltage of the load 300 when the first relay 110 is opened and the second relay 120 is short-circuited. For example, the controller 140 may open the first relay 110 and short-circuit the second relay 120, and obtain the voltage of the load 300 through the measuring unit 130. That is, when the second relay 120 is short-circuited, grounds of the battery pack 200 and the load 300 may be matched to each other, such that the measuring unit 130 may measure the voltage of the load 300 under the same condition as the voltage of the battery pack 200, and the controller 140 may obtain the voltage of the load 300 measured by the measuring unit 130. According to an embodiment, the controller 140 may match the ground of the load 300 with the ground of the battery pack 200 by short-circuiting the second relay 120.

The controller 140 may diagnose connectivity of the battery pack 200 or the load 300 based on the obtained voltage of the battery pack 200 or the obtained voltage of the load 300. For example, the controller 140 may diagnose connectivity of the battery pack 200 based on the obtained voltage of the battery pack 200. In another example, the controller 140 may diagnose connectivity of the load 300 based on the obtained voltage of the load 300.

The controller 140 diagnoses that abnormality has occurred in the connectivity of the battery pack 200, when the obtained voltage of the battery pack 200 is less than a first set value. For example, when abnormality occurs in the connectivity of the battery pack 200, a lower voltage value than an existing voltage value of the battery pack 200 may be obtained, such that the controller 140 may diagnose that abnormality has occurred in the connectivity of the battery pack 200.

The controller 140 diagnoses that abnormality has occurred in the connectivity of the load 300, when the obtained voltage of the load 300 exceeds a second set value. For example, when abnormality occurs in the connectivity of the load 300, a higher voltage value than an existing voltage value applied to the load 300 may be obtained, such that the controller 140 may diagnose that abnormality has occurred in the connectivity of the load 300.

According to an embodiment, the controller 140 may diagnose the connectivity of the battery pack 200 and the connectivity of the load 300 before short-circuiting both the first relay 110 and the second relay 120. For example, the controller 140 may open both the first relay 110 and the second relay 120 to diagnose the connectivity of the battery pack 200, short-circuit the second relay 120 to diagnose the connectivity of the load 300, and determine whether to connect the battery pack 200 to the load 300 based on a connectivity diagnosis result of the battery pack 200 and a connectivity diagnosis result of the load 300. In another example, the controller 140 may short-circuit both the first relay 110 and the second relay 120 to connect the battery pack 200 to the load 300 when both the connectivity diagnosis result of the battery pack 200 and the connectivity diagnosis result of the load 300 are normal. In another example, the controller 140 may not connect the battery pack 200 to the load 300 when at least any one of the connectivity diagnosis result of the battery pack 200 and the connectivity diagnosis result of the load 300 is not normal. In this case, the controller 140 may transmit information about the connectivity of the battery pack 200 or the connectivity of the load 300 to an external device (e.g., the higher-level controller 2 of FIG. 1) or provide, to a user, information indicating that abnormality has occurred in the connectivity of the battery pack 200 or the connectivity of the load 300.

According to an embodiment, when both the first relay 110 and the second relay 120 are opened, the measuring unit 130 and the battery pack 200 may form a closed circuit.

According to an embodiment, when the first relay 110 is opened and the second relay 120 is short-circuited, the measuring unit 130 and the load 300 may form a closed circuit.

The battery management apparatus according to an embodiment disclosed herein may diagnose connectivity of a battery pack side and connectivity of a load side.

The battery management apparatus according to an embodiment disclosed herein may measure a battery pack-side voltage and a load-side voltage through one ADC, and diagnose the connectivity of the battery pack side and the load side voltage based on the measured voltages.

The battery management apparatus according to an embodiment disclosed herein may diagnose the connectivity of the both sides with a simplified circuit by matching grounds of the battery pack side and the load side.

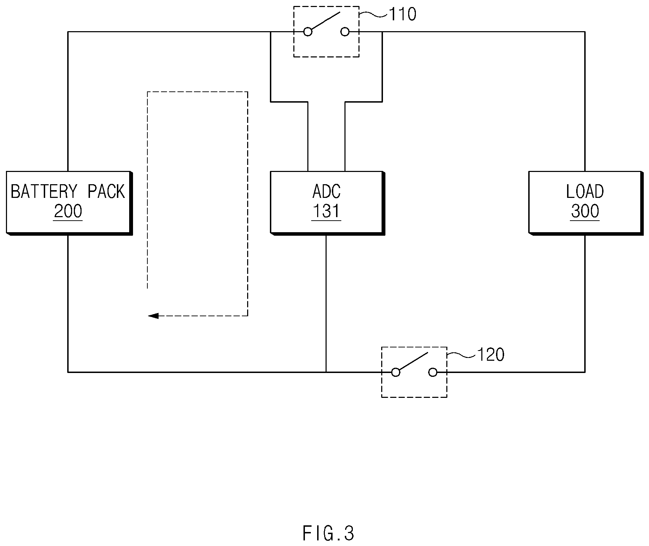

FIG. 3 shows an example of measuring a voltage of a battery pack according to an embodiment disclosed herein.

Referring to FIG. 3, the battery management apparatus 100 according to an embodiment disclosed herein may measure a voltage at a battery pack 200 side and obtain the measured voltage.

According to an embodiment, a controller (the controller 140 of FIG. 2) may open both the first relay 110 and the second relay 120, the voltage of the battery pack 200 may be measured through an ADC 131, and the measured voltage may be obtained by the controller (the controller 140 of FIG. 2).

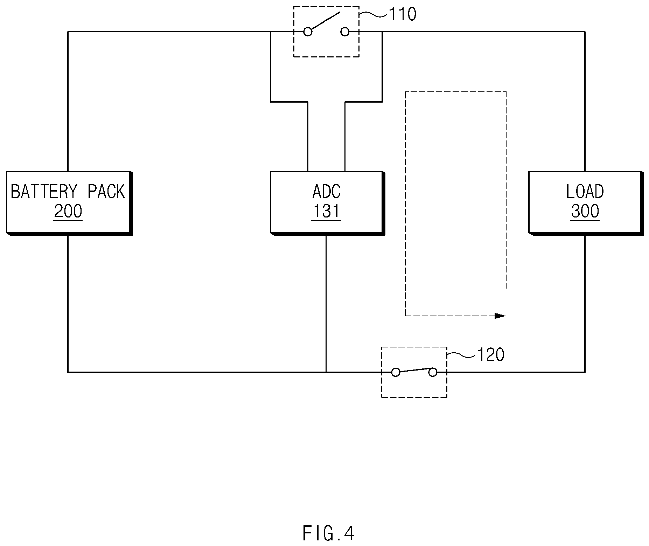

FIG. 4 shows an example of measuring a voltage on a load side according to an embodiment disclosed herein.

Referring to FIG. 4, the battery management apparatus 100 according to an embodiment disclosed herein may measure a voltage at a load 300 side and obtain the measured voltage.

According to an embodiment, the controller (the controller 140 of FIG. 2) may open the first relay 110 and short-circuit the second relay 120, the voltage of the load 300 may be measured through the ADC 131, and the measured voltage may be obtained by the controller (the controller 140 of FIG. 2).

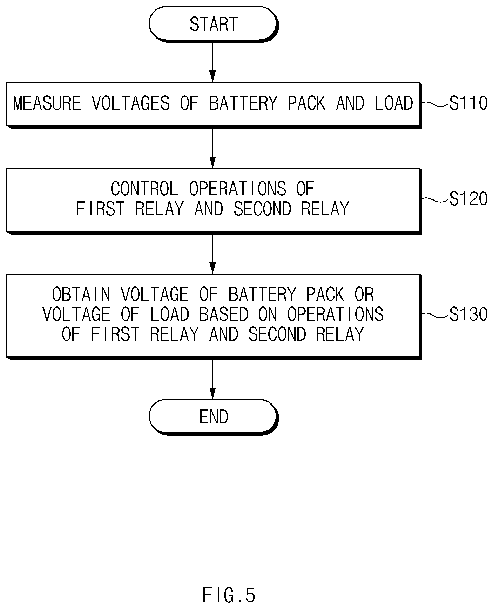

FIG. 5 is a flowchart of an operating method of a battery management apparatus according to an embodiment disclosed herein.

Referring to FIG. 5, an operating method of the battery management apparatus 100 according to an embodiment disclosed herein may include operation S110 of measuring voltages of a battery pack and a load, operation S120 of controlling operations of a first relay and a second relay, and operation S130 of obtaining the voltage of the battery pack or the voltage of the load based on the operations of the first relay and the second relay. According to an embodiment, operations shown in FIG. 5 may be performed by the battery management apparatus 100 of FIG. 2.

In operation S110 of measuring the voltages of the battery pack and the load, the measuring unit 130 may measure the voltages of the battery pack and the load. For example, the measuring unit 130 may include an ADC.

In operation S120 of controlling the operations of the first relay and the second relay, the controller 140 may control the operations of the first relay 110 and the second relay 120. For example, the controller 140 may generate control signals for controlling the operations of the first relay 110 and the second relay 120 to control the operations of the first relay 110 and the second relay 120.

In operation S130 of obtaining the voltage of the battery pack or the voltage of the load based on the operations of the first relay and the second relay, the controller 140 may obtain the voltage of the battery pack or the voltage of the load based on the operations of the first relay 110 and the second relay 120. For example, the controller 140 may obtain the voltage of the battery pack when the first relay 110 and the second relay 120 are opened. In another example, the controller 140 may obtain the voltage of the load when the first relay 110 is opened and the second relay 120 is short-circuited. According to an embodiment, the controller 140 may control the operations of the first relay 110 and the second relay 120, and obtain the voltage of the battery pack or the voltage of the load based on the operations of the first relay 110 and the second relay 120.

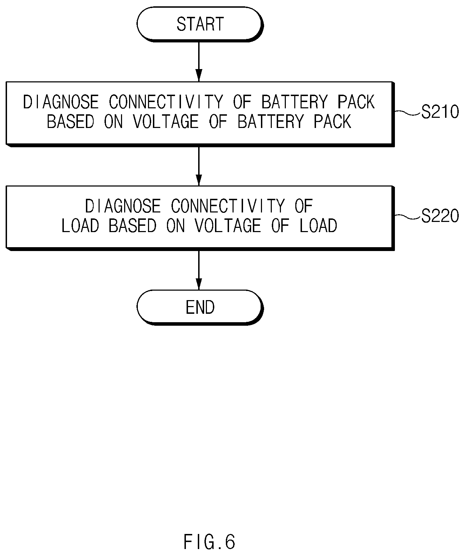

FIG. 6 is a flowchart showing an operating method of a battery management apparatus, according to an embodiment disclosed herein.

Referring to FIG. 6, an operating method of the battery management apparatus 100 according to an embodiment disclosed herein may further include operation S210 of diagnosing connectivity of the battery pack based on the voltage of the battery pack and operation S220 of diagnosing connectivity of the load based on the voltage of the load.

In operation S210 of diagnosing the connectivity of the battery pack based on the voltage of the battery pack, the controller 140 may diagnose the connectivity of the battery pack based on the voltage of the battery pack obtained from the measuring unit 130. According to an embodiment, the controller 140 may diagnose that abnormality has occurred in the connectivity of the battery pack, when the obtained voltage of the battery pack is less than a first set value. According to an embodiment, when abnormality occurs in the connectivity of the battery pack, a lower voltage value than an existing voltage value of the battery pack may be obtained, such that the controller 140 may diagnose that abnormality has occurred in the connectivity of the battery pack.

In operation S220 of diagnosing the connectivity of the load based on the voltage of the load, the controller 140 may diagnose the connectivity of the load based on the voltage of the load obtained from the measuring unit 130. For example, the controller 140 may diagnose that abnormality has occurred in the connectivity of the load, when the obtained voltage of the load exceeds a second set value. According to an embodiment, when abnormality occurs in the connectivity of the load, a higher voltage value than an existing voltage value applied to the load may be obtained, such that the controller 140 may diagnose that abnormality has occurred in the connectivity of the load.

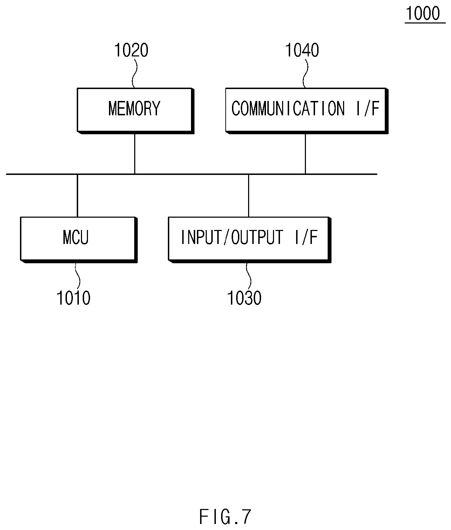

FIG. 7 is a block diagram showing a hardware configuration of a computing system for performing an operating method of a battery management apparatus, according to an embodiment disclosed herein.

Referring to FIG. 7, a computing system 1000 according to an embodiment disclosed herein may include an MCU 1010, a memory 1020, an input/output I/F 1030, and a communication I/F 1040.

The MCU 1010 may be a processor that executes various programs (e.g., a battery pack voltage or current collection program, a relay control program, a connectivity diagnosis program of a battery pack or load, etc.) stored in the memory 1020, processes various information including a voltage of a battery pack and a voltage of a load through these programs, and executes the above-described functions of the battery management apparatus shown in FIG. 2.

The memory 1020 may store various programs regarding log information collection and diagnosis of the battery, etc. The memory 1020 may store various information such as a current and a voltage of the battery, the voltage of the battery pack, the voltage of the load, etc.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery management apparatus may transmit and receive a relay control program or information such as a voltage and a current of various battery packs and the voltage of the load from an external server separately provided through the communication I/F 1040.

As such, a computer program according to an embodiment disclosed herein may be recorded in the memory 1020 and processed by the MCU 1010, thus being implemented as a module that performs functions shown in FIG. 2.

## Claims

1. A battery management apparatus (100) comprising:
a first relay (110) configured to connect an end of a battery pack (200) to an end of a load (300);
a second relay (120) configured to connect the other end of the battery pack (200) to the other end of the load (300);
a measuring unit (130) configured to measure voltages of the battery pack (200) and the load (300); and
a controller (140) configured to control operations of the first relay (110) and the second relay (120) and obtain the voltage of the battery pack (200) and the voltage of the load (300) based on the operations of the first relay (110) and the second relay (120);
**characterised in that**
the controller (140) is further configured to diagnose that abnormality has occurred in connectivity of the battery pack (200) when the obtained voltage of the battery pack (200) is less than a first set value, and to diagnose that abnormality has occurred in connectivity of the load (300) when the obtained voltage of the load (300) exceeds a second set value.

2. The battery management apparatus (100) of claim 1, wherein the controller (140) is further configured to obtain the voltage of the battery pack (200) when both the first relay (110) and the second relay (120) are opened.

3. The battery management apparatus (100) of claim 1, wherein the controller (140) is further configured to open the first relay (110), short-circuit the second relay (120), and obtain the voltage of the load (300).

4. The battery management apparatus (100) of claim 1, wherein the measuring unit (130) comprises an analog-to-digital converter, ADC.

5. The battery management apparatus (100) of claim 1, wherein the measuring unit (130) is located outside the battery pack (200).

6. The battery management apparatus (100) of claim 1, wherein the first relay (110) is a positive relay, and the second relay (120) is a negative relay.

7. The battery management apparatus (100) of claim 1, wherein the controller (140) is further configured to match a ground of the load (300) to a ground of the battery pack (200) by short-circuiting the second relay (120).

8. The battery management apparatus (100) of claim 1, wherein the controller (140) is further configured to:
diagnose connectivity of the battery pack by opening both the first relay and the second relay;
diagnose connectivity of the load by short-circuiting the second relay; and
short-circuit both the first relay and the second relay (120) when a connectivity diagnosis result of the battery pack and a connectivity diagnosis result of the load are normal.

9. The battery management apparatus (100) of claim 1, wherein the measuring unit (130) and the battery pack (200) form a closed circuit when both the first relay (110) and the second relay (120) are opened.

10. The battery management apparatus (100) of claim 1, wherein the measuring unit (130) and the load (300) form a closed circuit when the first relay (110) is opened and the second relay (120) is short-circuited.

11. An operating method of a battery management apparatus (100), the operating method comprising the following steps:
measuring voltages of the battery pack (200) and the load (300);
controlling operations of a first relay (110) and a second relay (120);
obtaining the voltage of the battery pack (200) and the voltage of the load (300) based on the operations of the first relay (110) and the second relay (120); and
diagnosing that abnormality has occurred in connectivity of the battery pack (200) when the obtained voltage of the battery pack (200) is less than a first set value;
**characterised in that** the operating method further comprises the following step:
diagnosing that abnormality has occurred in connectivity of the load (300) when the obtained voltage of the load (300) exceeds a second set value,
wherein the first relay (110) and the second relay (120) connect the battery pack (200) to the load (300).

12. The operating method of claim 11, wherein the obtaining of the voltage of the battery pack (200) or the voltage of the load (300) based on the operations of the first relay (110) and the second relay (120) comprises obtaining the voltage of the battery pack (200) when the first relay (110) is opened and the second relay (120) is opened.

13. The operating method of claim 11, wherein the obtaining of the voltage of the battery pack (200) or the voltage of the load (300) based on the operations of the first relay (110) and the second relay (120) comprises obtaining the voltage of the load (300) when the first relay (110) is opened and the second relay (120) is short-circuited.

## Patentansprüche

1. Batterieverwaltungsvorrichtung (100), umfassend:
ein erstes Relais (110), das konfiguriert ist, um ein Ende eines Batteriepacks (200) mit einem Ende einer Last (300) zu verbinden;
ein zweites Relais (120), das konfiguriert ist, um das andere Ende des Batteriepacks (200) mit dem anderen Ende der Last (300) zu verbinden;
eine Messeinheit (130), die konfiguriert ist, um Spannungen des Batteriepacks (200) und der Last (300) zu messen; und
eine Steuerung (140), die konfiguriert ist, um Operationen des ersten Relais (110) und des zweiten Relais (120) zu steuern und die Spannung des Batteriepacks (200) und die Spannung der Last (300) basierend auf den Operationen des ersten Relais (110) und des zweiten Relais (120) zu erhalten;
**dadurch gekennzeichnet, dass**
die Steuerung (140) ferner konfiguriert ist, um zu diagnostizieren, dass eine Anomalie in der Konnektivität des Batteriepacks (200) aufgetreten ist, wenn die erhaltene Spannung des Batteriepacks (200) kleiner als ein erster eingestellter Wert ist, und um zu diagnostizieren, dass eine Anomalie in der Konnektivität der Last (300) aufgetreten ist, wenn die erhaltene Spannung der Last (300) einen zweiten eingestellten Wert überschreitet.

2. Batterieverwaltungsvorrichtung (100) nach Anspruch 1, wobei die Steuerung (140) ferner konfiguriert ist, um die Spannung des Batteriepacks (200) zu erhalten, wenn sowohl das erste Relais (110) als auch das zweite Relais (120) geöffnet sind.

3. Batterieverwaltungsvorrichtung (100) nach Anspruch 1, wobei die Steuerung (140) ferner konfiguriert ist, um das erste Relais (110) zu öffnen, das zweite Relais (120) kurzzuschließen und die Spannung der Last (300) zu erhalten.

4. Batterieverwaltungsvorrichtung (100) nach Anspruch 1, wobei die Messeinheit (130) einen Analog-Digital-Wandler, ADC, umfasst.

5. Batterieverwaltungsvorrichtung (100) nach Anspruch 1, wobei sich die Messeinheit (130) außerhalb des Batteriepacks (200) befindet.

6. Batterieverwaltungsvorrichtung (100) nach Anspruch 1, wobei das erste Relais (110) ein positives Relais ist und das zweite Relais (120) ein negatives Relais ist.

7. Batterieverwaltungsvorrichtung (100) nach Anspruch 1, wobei die Steuerung (140) ferner konfiguriert ist, um eine Masse der Last (300) an eine Masse des Batteriepacks (200) anzupassen, indem das zweite Relais (120) kurzgeschlossen wird.

8. Batterieverwaltungsvorrichtung (100) nach Anspruch 1, wobei die Steuerung (140) ferner konfiguriert ist, um:
die Konnektivität des Batteriepacks zu diagnostizieren, indem sowohl das erste Relais als auch das zweite Relais geöffnet werden;
die Konnektivität der Last zu diagnostizieren, indem das zweite Relais kurzgeschlossen wird; und
sowohl das erste Relais als auch das zweite Relais (120) kurzzuschließen, wenn ein Konnektivitätsdiagnoseergebnis des Batteriepacks und ein Konnektivitätsdiagnoseergebnis der Last normal sind.

9. Batterieverwaltungsvorrichtung (100) nach Anspruch 1, wobei die Messeinheit (130) und das Batteriepack (200) einen geschlossenen Stromkreis bilden, wenn sowohl das erste Relais (110) als auch das zweite Relais (120) geöffnet sind.

10. Batterieverwaltungsvorrichtung (100) nach Anspruch 1, wobei die Messeinheit (130) und die Last (300) einen geschlossenen Stromkreis bilden, wenn das erste Relais (110) geöffnet ist und das zweite Relais (120) kurzgeschlossen ist.

11. Betriebsverfahren einer Batterieverwaltungsvorrichtung (100), wobei das Betriebsverfahren die folgenden Schritte umfasst:
Messen von Spannungen des Batteriepacks (200) und der Last (300);
Steuern von Operationen eines ersten Relais (110) und eines zweiten Relais (120);
Erhalten der Spannung des Batteriepacks (200) und der Spannung der Last (300) basierend auf den Operationen des ersten Relais (110) und des zweiten Relais (120); und
Diagnostizieren, dass eine Anomalie in der Konnektivität des Batteriepacks (200) aufgetreten ist, wenn die erhaltene Spannung des Batteriepacks (200) kleiner als ein erster eingestellter Wert ist;
**dadurch gekennzeichnet, dass** das Betriebsverfahren ferner den folgenden Schritt umfasst:
Diagnostizieren, dass eine Anomalie in der Konnektivität der Last (300) aufgetreten ist, wenn die erhaltene Spannung der Last (300) einen zweiten eingestellten Wert überschreitet,
wobei das erste Relais (110) und das zweite Relais (120) das Batteriepack (200) mit der Last (300) verbinden.

12. Betriebsverfahren nach Anspruch 11, wobei das Erhalten der Spannung des Batteriepacks (200) oder der Spannung der Last (300) basierend auf den Operationen des ersten Relais (110) und des zweiten Relais (120) das Erhalten der Spannung des Batteriepacks (200) umfasst, wenn das erste Relais (110) geöffnet ist und das zweite Relais (120) geöffnet ist.

13. Betriebsverfahren nach Anspruch 11, wobei das Erhalten der Spannung des Batteriepacks (200) oder der Spannung der Last (300) basierend auf den Operationen des ersten Relais (110) und des zweiten Relais (120) das Erhalten der Spannung der Last (300) umfasst, wenn das erste Relais (110) geöffnet ist und das zweite Relais (120) kurzgeschlossen ist.

## Revendications

1. Appareil de gestion de batterie (100) comprenant :
un premier relais (110) configuré pour connecter une extrémité d'un bloc-batterie (200) à une extrémité d'une charge (300) ;
un deuxième relais (120) configuré pour connecter l'autre extrémité du bloc-batterie (200) à l'autre extrémité de la charge (300) ;
une unité de mesure (130) configurée pour mesurer des tensions du bloc-batterie (200) et de la charge (300) ; et
un organe de commande (140) configuré pour commander des fonctionnements du premier relais (110) et du deuxième relais (120) et obtenir la tension du bloc-batterie (200) et la tension de la charge (300) sur la base des fonctionnements du premier relais (110) et du deuxième relais (120) ;
**caractérisé en ce que**
l'organe de commande (140) est configuré en outre pour diagnostiquer si une anomalie s'est produite dans la connectivité du bloc-batterie (200) lorsque la tension obtenue du bloc-batterie (200) est inférieure à une première valeur de consigne, et pour diagnostiquer si une anomalie s'est produite dans la connectivité de la charge (300) lorsque la tension obtenue de la charge (300) dépasse une deuxième valeur de consigne.

2. Appareil de gestion de batterie (100) de la revendication 1, dans lequel l'organe de commande (140) est configuré en outre pour obtenir la tension du bloc-batterie (200) lorsqu'à la fois le premier relais (110) et le deuxième relais (120) sont ouverts.

3. Appareil de gestion de batterie (100) de la revendication 1, dans lequel l'organe de commande (140) est configuré en outre pour ouvrir le premier relais (110), court-circuiter le deuxième relais (120), et obtenir la tension de la charge (300).

4. Appareil de gestion de batterie (100) de la revendication 1, dans lequel l'unité de mesure (130) comprend un convertisseur analogique-numérique, ADC.

5. Appareil de gestion de batterie (100) de la revendication 1, dans lequel l'unité de mesure (130) est située à l'extérieur du bloc-batterie (200).

6. Appareil de gestion de batterie (100) de la revendication 1, dans lequel le premier relais (110) est un relais positif, et le deuxième relais (120) est un relais négatif.

7. Appareil de gestion de batterie (100) de la revendication 1, dans lequel l'organe de commande (140) est configuré en outre pour faire concorder une terre de la charge (300) à une terre du bloc-batterie (200) en court-circuitant le deuxième relais (120).

8. Appareil de gestion de batterie (100) de la revendication 1, dans lequel l'organe de commande (140) est configuré en outre pour :
diagnostiquer la connectivité du bloc-batterie en ouvrant à fois le premier relais et le deuxième relais ;
diagnostiquer la connectivité de la charge en court-circuitant le deuxième relais ; et
court-circuiter à la fois le premier relais et le deuxième relais (120) lorsqu'un résultat de diagnostic de connectivité du bloc-batterie et un résultat de diagnostic de connectivité de la charge sont normaux.

9. Appareil de gestion de batterie (100) de la revendication 1, dans lequel l'unité de mesure (130) et le bloc-batterie (200) forment un circuit fermé lorsqu'à la fois le premier relais (110) et le deuxième relais (120) sont ouverts.

10. Appareil de gestion de batterie (100) de la revendication 1, dans lequel l'unité de mesure (130) et la charge (300) forment un circuit fermé lorsque le premier relais (110) est ouvert et que le deuxième relais (120) est court-circuité.

11. Procédé de fonctionnement d'un appareil de gestion de batterie (100), le procédé de fonctionnement comprenant les étapes suivantes consistant à :
mesurer des tensions du bloc-batterie (200) et de la charge (300) ;
commander des fonctionnements d'un premier relais (110) et d'un deuxième relais (120) ;
obtenir la tension du bloc-batterie (200) et la tension de la charge (300) sur la base des fonctionnements du premier relais (110) et du deuxième relais (120) ; et
diagnostiquer si une anomalie s'est produite dans la connectivité du bloc-batterie (200) lorsque la tension obtenue du bloc-batterie (200) est inférieure à une première valeur de consigne ;
**caractérisé en ce que** le procédé de fonctionnement comprend en outre l'étape suivante consistant à :
diagnostiquer si une anomalie s'est produite dans la connectivité de la charge (300) lorsque la tension obtenue de la charge (300) dépasse une deuxième valeur de consigne,
dans lequel le premier relais (110) et le deuxième relais (120) connectent le bloc-batterie (200) à la charge (300).

12. Procédé de fonctionnement de la revendication 11, dans lequel l'obtention de la tension du bloc-batterie (200) ou de la tension de la charge (300), sur la base des fonctionnements du premier relais (110) et du deuxième relais (120) comprend l'obtention de la tension du bloc-batterie (200) lorsque le premier relais (110) est ouvert et que le deuxième relais (120) est ouvert.

13. Procédé de fonctionnement de la revendication 11, dans lequel l'obtention de la tension du bloc-batterie (200) ou de la tension de la charge (300), sur la base des fonctionnements du premier relais (110) et du deuxième relais (120) comprend l'obtention de la tension de la charge (300) lorsque le premier relais (110) est ouvert et que le deuxième relais (120) est court-circuité.
